Europäisches Patentamt

European Patent Office

Office européen des brevets

(11) Veröffentlichungsnummer: **0 072 403**
**B1**

## EUROPÄISCHE PATENTSCHRIFT

(45) Veröffentlichungstag der Patentschrift:
16.09.87

(51) Int. Cl.⁴: **H 04 B 1/66,** H 03 D 3/00

(21) Anmeldenummer: 82105452.5

(22) Anmeldetag: **22.06.82**

(54) Demodulator für frequenzmodulierte Signale mit gespreiztem Spektrum.

(30) Priorität: 17.08.81 DE 3132376

(43) Veröffentlichungstag der Anmeldung:
23.02.83 Patentblatt 83/8

(45) Bekanntmachung des Hinweises auf die Patenterteilung:
16.09.87 Patentblatt 87/38

(84) Benannte Vertragsstaaten:
BE DE FR GB IT NL

(56) Entgegenhaltungen:
US - A - 3 710 261

R.C. DIXON: "Spread spectrum systems", 1976, J. Wiley & Sons, Inc., New York, US
NTG - FACHBERICHTE, Band 65, 1978, Seiten 410-416, Berlin, DE, K.H. ANNECKE: "Synchronisation von mod2 kombinierten Trägern in asynchronen Breitbandnetzen"
NTG - FACHBERICHTE
W.C. LINDSEY u.a.: "Telecommunication systems engineering", 1973, Prentice-Hall, Inc., Englewood Cliffs, New Jersey, US

(73) Patentinhaber: ANT Nachrichtentechnik GmbH,
Gerberstrasse 33, D-7150 Backnang (DE)

(72) Erfinder: Annecke, Karl Heinz, Dr.-Ing.,
Nansenstrasse 25/2, D-7150 Backnang (DE)

(74) Vertreter: Schickle, Gerhard, Dipl.-Ing. et al, ANT
Nachrichtentechnik GmbH Patent- und Lizenzabteilung
Gerberstrasse 33, D-7150 Backnang (DE)

**Beschreibung**

Die vorliegende Erfindung betrifft einen Demodulator für Nachrichtensignale, die vor ihrer Frequenzmodulation durch Multiplikation mit einem Breitbandsignal eine Spreizung ihres Spektrums erfahren haben, bestehend aus einem Phasenregelkreis mit einem Phasendiskriminator, einem daran angeschlossenen Schleifenfilter und einem spannungsgesteuerten Oszillator im Rückkopplungszweig.

Es ist z. B. aus «Spread spectrum systems», R.C. DIXON, 1976, J. Wiley & Sons, Inc., New York oder aus «Prinziples of Communication Systems», Taub u. Schilling, McGraw-Hill Book Company 1971, S. 339 bis 359, bekannt, als Demodulator für ein frequenzmoduliertes Nachrichtensignal einen Phasenregelkreis (PLL) einzusetzen.

Von einem solchen Phasenregelkreis wird gefordert, die Phasen- oder Zeitlage eines empfangenen Signals möglichst schnell zu erkennen bzw. die Phasen- oder Zeitlage eines Referenzsignals mit der des empfangenen Signals möglichst schnell in Übereinstimmung zu bringen. Man nennt diesen Prozess Synchronisation.

Eine derartige Synchronisation bewältigen herkömmliche Phasenregelkreise problemlos, sofern es sich um Nachrichtensignale handelt mit kleinem Zeit-Bandbreiteprodukt.

Im folgenden soll aber die Demodulation von frequenzmodulierten Nachrichtensignalen mit gespreiztem Spektrum, d.h. mit grossem Zeit-Bandbreiteprodukt, behandelt werden. Denn durch die Spreizung ihres Spektrums erlangen die Signale eine grössere Störsicherheit bei der Übertragung.

Der Erfindung liegt nun die Aufgabe zugrunde, einen als Phasenregelkreis ausgebildeten Demodulator für frequenzmodulierte Nachrichtensignale mit gespreiztem Spektrum anzugeben, dessen Schleifenfilter bei möglichst geringem schaltungstechnischem Aufwand eine schnelle und korrekte Synchronisation gewährleistet.

Diese Aufgabe wird erfindungsgemäss durch die Merkmale des Anspruchs 1 gelöst.

Eine zweckmässige Ausführung der Erfindung geht aus dem Unteranspruch hervor.

Ein nichtlineares entscheidungsgesteuertes Filter derart, dass es aus dem von Störungen überlagerten Schätzwert eines Signals mit gespreiztem Spektrum die übertragene Nachricht und das Breitbandsignal wiedererkennt, ist in NTG-Fachberichte Band 65, S. 410 bis 415, beschrieben. Allerdings ist hieraus nicht der Einsatz dieses Filters in einem PLL-Demodulator bekannt.

Durch die erfindungsgemäss in den Demodulationsprozess einbezogene Synchronisation mit Hilfe des nichtlinearen entscheidungsgestützten Filters ist auch schon bei einem schlechten Signal/Rauschleistungsverhältnis am Eingang des Phasenregelkreises ein Einrasten desselben gewährleistet.

Anhand eines in der Zeichnung dargestellten Ausführungsbeispiels wird nachfolgend die Erfindung näher erläutert. Es zeigen:

Fig. 1 den Modulator zur Erzeugung eines frequenzmodulierten Nachrichtensignals mit gespreiztem Spektrum

Fig. 2 einen Phasenregelkreis zur Demodulation dieses Signals und

Fig. 3 ein in das Schleifenfilter des Phasenregelkreises eingesetztes rekursives Filter.

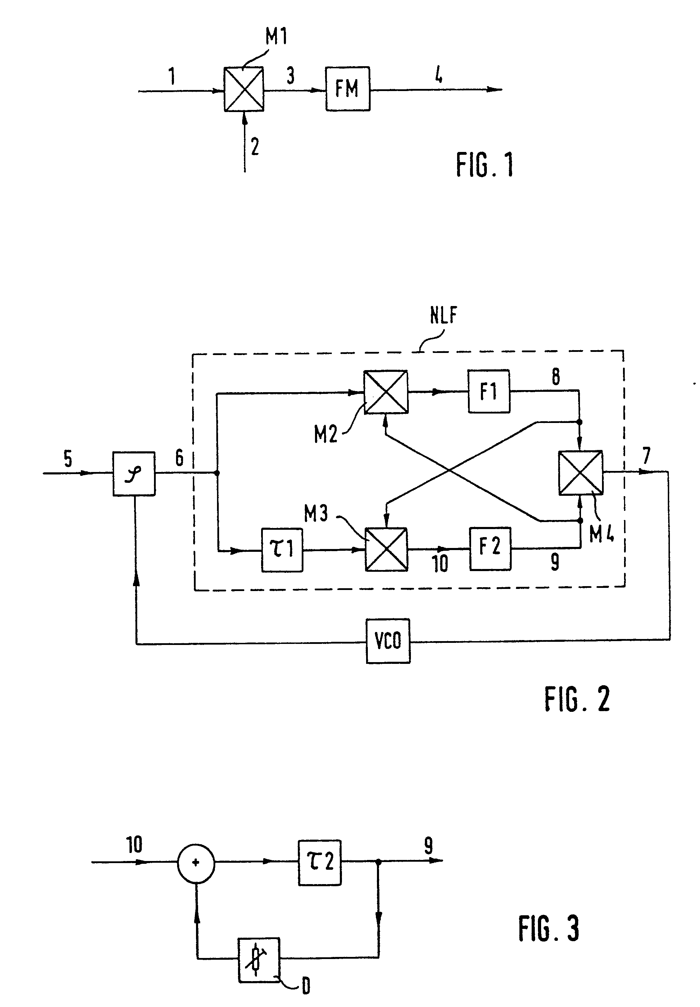

In der Fig. 1 ist das Blockschaltbild eines Modulators dargestellt, mit dem ein frequenzmoduliertes Signal mit gespreiztem Spektrum gebildet wird. Auf einen Multiplizierer M1 wird ein Nachrichtensignal 1 und ein Breitbandsignal 2 gegeben. Das Produkt dieser beiden Signale ist ein Signal 3 mit gespreiztem Spektrum, das anschliessend einem Frequenzmodulator FM zugeführt wird, an dessen Ausgang schliesslich das frequenzmodulierte Signal 4 mit gespreiztem Spektrum erscheint.

Dieses so erzeugte Signal 4 gelangt über die Übertragungsstrecke zum in der Fig. 2 gezeigten Demodulator. Am Eingang des Demodulators liegt nach einer hier nicht dargestellten Bandpassfilterung das frequenzmodulierte Signal 5 mit gespreiztem Spektrum. Der Demodulator ist ein (Phase Locked loop) Phasenregelkreis mit einem Phasendiskriminator φ, einem an dessen Ausgang angeschlossenen Schleifenfilter (Loopfilter) NLF und einem spannungsgesteuerten Oszillator VCO, der im Rückkopplungszweig zwischen dem Schleifenfilterausgang und einem Eingang des Phasendiskriminators liegt.

Das in den Phasenregelkreis eingesetzte Schleifenfilter ist ein nichtlineares, entscheidungsgesteuertes Filter NLF, das die Synchronisation des geschätzten Signals 7 im Phasenregelkreis bewerkstelligt. Das Signal 6 ist ein von Störungen überlagerter Schätzwert des Signals 3, das durch Multiplikation des Nachrichtensignals 1 mit dem Breitbandsignal 2 im Modulator nach Fig. 1 entstanden ist. Das nichtlineare entscheidungsgesteuerte Filter NLF besteht aus zwei von dem Signal 6 gespeisten Signalwegen. Der erste Signalweg enthält einen Multiplizierer M2 und ein an dessen Ausgang geschaltetes Tiefpassfilter F1 mit der Grenzfrequenz des Nachrichtensignals 1. Der zweite Signalweg besteht aus der Reihenschaltung eines Laufzeitgliedes τ1, eines Multiplizierers M3 und eines Filters F2. Das Laufzeitglied besitzt die gleiche Laufzeitverzögerung wie das Tiefpassfilter F1 im ersten Signalweg. Beide Signalwege sind an die Eingänge eines mit dem spannungsgesteuerten Oszillator VCO verbundenen Multiplizierers M4 angeschlossen. Ausserdem ist jeweils das Ausgangssignal des einen Signalweges auf einen Eingang des im anderen Signalweg liegenden Multiplizierers rückgekoppelt.

Die Funktionsweise des soeben beschriebenen nichtlinearen entscheidungsgesteuerten Filters NLF sei im folgenden erläutert: Am Ausgang des Multiplizierers M4 liegt ein Schätzwert 7 des gespreizten Nachrichtensignals 3. Dieser Schätzwert 7 entsteht durch Multiplikation des Schätzwertes 8 des Nachrichtensignals 1, der am Ausgang des ersten Signalweges erscheint, und des Schätzwertes 9 des Breitbandsignals 2, der am Ausgang des zweiten Signalweges erscheint. Der Schätzwert 8 des Nachrichtensignals resultiert aus der Multiplikation des Signals 6, welcher ein von Störungen überlagerter Schätzwert des Signals 3 ist, mit dem Schätzwert 9 des Breitbandsignals 2. Und der Schätzwert 9 des Breitbandsignals 2 resultiert aus der Multiplikation des Schätzwerts 8 des Nachrichtensignals 1 mit dem um die Laufzeit des Tiefpassfilters F1 verzögerten Signals 6.

Das in den zweiten Signalweg eingesetzte Filter F2 ist z.B. ein rekursives Filter, wie es die Fig. 3 zeigt. Es bewirkt eine Verbesserung des Signal/Rauschleistungsverhältnisses zwischen dem Eingangssignal 10 und dem Ausgangssignal 9. Dieses Filter enthält ein Laufzeitglied τ2 mit einer Verzögerungszeit, die der Periodendauer des Breitbandsignals 2 entspricht. Das Ausgangssignal 9 des Laufzeitgliedes τ2 wird über ein Dämpfungsglied D an den Eingang zurückgeführt und dort zum Eingangssignal 10 addiert.

Für die Verbesserung des Signal/Rauschleistungsverhältnisses kommen auch andere Filter infrage; so z.B. Filter mit speziellen Eigenschaften wie sie in der deutschen Offenlegungsschrift DE-A-30 29 249 (veröffentlicht am 18.2.1982) beschrieben sind.

## Patentansprüche

1. Demodulator für Nachrichtensignale, die vor ihrer Frequenzmodulation durch Multiplikation mit einem Breitbandsignal eine Spreizung ihres Spektrums erfahren haben, bestehend aus einem Phasenregelkreis mit einem Phasendiskriminator (φ), einem daran angeschlossenen Schleifenfilter (NLF) und einem spannungsgesteuerten Oszillator (VCO) im Rückkopplungszweig, dadurch gekennzeichnet, dass das Schleifenfilter (NLF) aus zwei an den Ausgang des Phasendiskriminators (φ) angeschlossenen Signalwegen besteht, von denen der eine einen Multiplizierer (M2) und ein an dessen Ausgang geschaltetes Tiefpassfilter (F1) mit der Grenzfrequenz des Nachrichtensignals (1) enthält und der andere Signalweg aus der Serienschaltung eines Laufzeitgliedes (τ1), das die gleiche Laufzeitverzögerung wie das Tiefpassfilter (F1) hat, eines Multiplizierers (M3) und eines an das Breitbandsignal (2) angepassten Filters (F2) gebildet ist, dass jeweils der Ausgang des Filters (F1, F2) im einen Signalzweig auf den Multiplizierer (M3, M2) im anderen Signalzweig zurückgeführt ist und dass die Ausgänge der beiden Filter (F1, F2) mit den Eingängen eines Multiplizierers (M4) verbunden sind, dessen Ausgangssignal (7) an den spannungsgesteuerten Oszillator (VCO) gelegt ist.

2. Demodulator nach Anspruch 1, dadurch gekennzeichnet, dass das an das Breitbandsignal (2) angepasste Filter (F2) ein rekursives Filter ist, bestehend aus einem Laufzeitglied (τ2), dessen Laufzeit der Periodendauer T des Breitbandsignals (2) entspricht, und einem dem Laufzeitglied (τ2) vorgeschalteten Addierer, mit dem dem Eingangssignal (10) des Filters das über ein Dämpfungsglied (D) geleitete Ausgangssignal (9) des Laufzeitgliedes (2) überlagert wird.

## Claims

1. Demodulator for communications signals which, before frequency modulation, have had their spectrum spread by multiplication with a broadband signal, the demodulator being composed of a phase regulating circuit including a phase discriminator (φ), a loop filter (NLF) connected thereto and a voltage controlled oscillator (VCO) in the feedback branch, characterized in that the loop filter (NLF) is composed of two signal paths connected to the output of the phase discriminator (φ) of which one path includes a multiplier (M2) and a lowpass filter (F1) connected to the output of the multiplier and having the limit frequency of the communication signal (1) and the other signal path is composed of the series connection of a delay member (τ1) which has the same delay as the lowpass filter (F1), a multiplier (M3) and a filter (F2) matched to the broadband signal (2); the output of the filter (F1, F2) in each signal branch is fed back to the multiplier (M3, M2) in the respective other signal branch and the outputs of both filters (F1, F2) are connected with the inputs of a multiplier (M4) whose output signal (7) is applied to the voltage controlled oscillator (VCO).

2. Demodulator according to claim 1, characterized in that the filter (F2) matched to the broadband signal (2) is a recursive filter composed of a delay member (τ2) whose delay corresponds to the period duration T of the broadband signal (2) and an adder connected ahead of the delay member (τ2), said adder being used to superpose the output signal (9) of the delay member (2) [sic] conducted through an attenuation member (D) over the input signal (10) of the filter.

## Revendications

1. Démodulateur de signaux d'information dont le spectre a été étalé avant leur modulation en fréquence par multiplication par un signal à large bande, constitué par une boucle à verrouillage de phase avec un discriminateur de phase (φ), un filtre de boucle (NLF) relié à ce dernier et un oscillateur commandé en tension (VCO) dans la boucle de réaction, ledit démodulateur étant caractérisé en ce que le filtre de boucle (NLF) est constitué par deux circuits de signal reliés à la sortie du discriminateur de phase (φ), dont un comprend un multiplicateur (M2) et un filtre passe-bas (F1) relié à la sortie de ce dernier et avec la fréquence de coupure du signal d'information (1), et dont le second circuit est constitué par le montage en série d'un élément de retard (τ1), présentant le même retard du temps de propagation que le filtre passe-bas (F1) un multiplicateur (M3) et un filtre (F2) adapté au signal à large bande (2); la sortie de chaque filtre (F1, F2) d'un circuit de signal est ramenée sur le multiplicateur (M3, M2) de l'autre circuit de signal; et les sorties des deux filtres (F1, F2) sont reliées aux entrées d'un multiplicateur (M4) dont le signal de sortie (7) est appliqué à l'oscillateur commandé en tension (VCO).

2. Démodulateur selon revendication 1, caractérisé en ce que le filtre (F2) adapté au signal à large bande (2) est un filtre récursif constitué par un élément de retard ($\tau$2), dont le retard est égal à la période T du signal à large bande (2), et un additionneur branché en amont de l'élément de retard ($\tau$2) et superposant au signal d'entrée (10) du filtre le signal de sortie (9) de l'élément de retard ($\tau$2) transmis par un atténuateur (D).

FIG. 1

FIG. 2

FIG. 3